(19) Europäisches Patentamt

European Patent Office

Office européen des brevets

(11) Veröffentlichungsnummer: **0 140 095**
**B1**

(12) # EUROPÄISCHE PATENTSCHRIFT

(45) Veröffentlichungstag der Patentschrift: **19.12.90**

(51) Int. Cl.⁵: **H 01 L 29/90, H 01 L 27/02**

(21) Anmeldenummer: **84110893.9**

(22) Anmeldetag: **12.09.84**

(54) Halbleiterdiode.

(30) Priorität: **21.09.83 DE 3334167**

(43) Veröffentlichungstag der Anmeldung:
**08.05.85 Patentblatt 85/19**

(45) Bekanntmachung des Hinweises auf die
Patenterteilung:
**19.12.90 Patentblatt 90/51**

(84) Benannte Vertragsstaaten:
**DE FR GB IT**

(56) Entgegenhaltungen:
FR-A-1 551 956
FR-A-2 030 175

Die Akte enthält technische Angaben, die nach
dem Eingang der Anmeldung eingereicht
wurden und die nicht in dieser Patentschrift
enthalten sind.

(73) Patentinhaber: **Siemens Aktiengesellschaft
Wittelsbacherplatz 2
D-8000 München 2 (DE)**

(72) Erfinder: **Huber, Jakob, Dipl.-Phys.
Flurweg 35
D-8201 Beyharting (DE)**
Erfinder: **Pettenpaul, Ewald, Dr. Ing.
Fasanenstrasse 68 b
D-8025 Unterhaching (DE)**

(56) References cited:

**MICROELECTRONICS AND RELIABILITY, Band
22, Nr. 2, 1982, Seiten 187-193, Pergamon Press,
Oxford, GB; C.A. MILLER et al.: "Punch-through
gate protection of M.O.S. devices"**
**E.Spenke:"pn-Uebergänge", Springer-Verlag,
Berlin 1979, S.51-52 u. 58-61.**

**IEEE Journal of Solid-State Circuits, Vol.SC-17,
No.4, August 1982, S.648-652.**
**W.von Münch:"Technologie der Galliumarsenid-
Bauelemente", Springer-Verlag, Berlin 1969, S.9-
10.**

Courier Press, Leamington Spa, England.

## Beschreibung

Die Erfindung betrifft einen planaren elektronischen Halbleiter-Bauelement-Körper mit einem semi-isolierenden Substrat aus Verbindungs-Halbleitermaterial und mit einer Halbleiter-Schutzdiode zum Schutz für mindestens ein auf dem Substrat integriertes Halbleiter-Bauelement gegen statische Entladung.

Eine Halbleiterdiode ist aus der europäischen Patentschrift 0 003 130 als Bulk-Diode bekannt, die eine NPN- oder PNP-Dreischichstruktur aus drei aneinandergrenzenden Halbleiterschichten mit ohmschen Kontakten aufweist und bei der zur Verringerung der Energiebarriere die in der Dreischichtstruktur mittlere Schicht in ihrer Dicke so dünn gewählt ist, daß bereits ohne äußere an die Elektroden angelegte elektrische Spannung bei der gegebenen Dotierung dieser Schicht der gesamte Bereich dieser Schicht von freien Ladungsträgern verarmt ist. Derartige Dioden, die als Bulk-Dioden ausgebildet sind, eignen sich nur schwer oder nicht zum Einsatz als Schutzdioden bei Galliumarsenid-Bauelementen, zumal dafür hohe p-Dotierungen in Galliumarsenid einzuhringen wären, was bekanntlich schwierig bzw. unmöglich ist. Andererseits sind Galliumarsenid-Bauelemente, die auf semi-isolierenden Substraten gefertigt sind, sehr empfindlich gegen statische Entladung. Bisher werden deshalb auf semi-isolierenden Substraten aus Verbindungshalbleitern keine Schutzdioden eingebaut. Wegen der Empfindlichkeit von Galliumarsenid-Bauelementen gegen statische Entladungen und wegen der Tatsache, daß derartige Bauelemente überwiegend als planare Bauelemente auf einem semi-isolierenden Substrat ausgebildet sind, wäre ein Konzept für die Herstellung von planaren Schutzdioden für Galliumarsenid-Bauelemente auf semi-isolierenden Substraten von besonderer Wichtigkeit.

Aus "Microelectronics and Reliability", Band 22 (1982), Nr. 2, Seiten 187—193, ist ein planarer elektronischer Halbleiter-Bauelement-Körper bekannt mit einem Substrat, mit einer auf dem Substrat des Halbleiter-Bauelements integrierten Schutzdiode zum Schutz für mindestens ein anderes auf dem Substrat integriertes Halbleiter-Bauelement gegen statische Entladung. Dabei besteht die Halbleiter-Schutzdiode aus drei aneinander grenzenden Bereichen, bei denen zwei dotierte Bereiche derselben Dotierungsart durch einen dritten Bereich getrennt sind und bei denen die zwei dotierten Bereiche derselben Dotierungsart ohmsche Kontakte aufweisen. Ferner weist der dritte Bereich derartige geometrische Abmessungen auf, daß die Halbleiter-Schutzdiode eine vorgegebenen Schwellwertspannung aufweist, und die ohmschen Kontakte auf den zwei dotierten Bereichen derselben Dotierungsart einen Abstand zum dritten Bereich hin aufweisen.

Aus "IEEE Journal of Solid-State Circuits", Band SC-17, Nr. 4, August 1982, Seiten 648—652, ist ein in ein GaAs-Substrat integrierter MESFET bekannt, der durch eine Schutzdiode gegen statische Entladungen geschützt wird. Dabei ist die Schutzdiode auf einem gesonderten, aus Silizium bestehenden Substrat angeordnet.

Ausgehend von dem aus der angegebenen Veröffentlichung "Microelectronics and Reliability" hervorgehenden Stand der Technik liegt der vorliegenden Erfindung die Aufgabe zugrunde, eine einen Schwellwert aufweisende Schutzdiode so zu gestalten, daß sie in ein semi-isolierendes Substrat aus Verbindungshalbleitermaterial integrierbar ist.

Diese Aufgabe wird durch einen planaren elektronischen Halbleiter-Bauelement-Körper mit einer auf dem Substrat des Halbleiter-Bauelement-Körpers integrierten Halbleiter-Schutzdiode nach dem Patenanspruch 1 gelöst.

Eine solche Diode weist in vorteilhafter Weise die Möglichkeit auf, Schutzdioden für Galliumarsenid-Bauelemente auf semi-isolierenden Substraten herzustellen, und das mit einem relativ geringen Kostenaufwand und mit üblichen technisch erprobten Verfahren zu verwirklichen.

Es ist auch vorteilhaft, daß das semi-isolierende Halbleitersubstrat aus einem binären, ternären oder quaternären Verbindungshalbleiter, insbesondere aus Galliumarsenid, Indiumphosphid oder Galliumaluminiumarsenid besteht.

Erfindungsgemäße Dioden sind auf derartigen Substraten technisch leicht und wenig kostenaufwendig herstellbar. Entsprechende bisher bekannte Dioden, z.B. NPN-Dioden lassen sich insbesondere auf Substraten aus Verbindungshalbleitern praktisch nicht erzeugen, da hierfür erforderliche hohe P-Konzentrationen von ca. $10^{20}$ Dotierstoffatomen pro ccm nicht mit dem gewünschten Erfolg herstellbar sind. Bei sehr hohen Dotierungen von Verbindungshalbleitern kann zum einen die Kristallstruktur so stark geschädigt werden, daß entweder der zu erreichende Effekt ausbleibt oder, infolge des amphoteren Charakters von Dotierstoffen in Verbindungshalbleitern der erzielte Effekt eine gegenteilige Wirkung ausübt.

Es ist auch erfinderisch, daß die zwei dotierten Bereiche derselben Dotierungsart eine n-Dotierung besitzen. N-Dotierungen sind in den üblichen Verbindungshalbleitern leichter herstellbar als p-Dotierungen.

In gewissen Fällen kann es auch vorteilhaft sein, daß die zwei dotierten Bereiche derselben Dotierungsart eine p-Dotierung besitzen.

In vielen Anwendungsfällen ist es vorteilhaft, daß die zwei dotierten Bereiche derselben Dotierungsart die gleiche Dotierungskonzentration aufweisen.

In bestimmten Anwendungsfällen ist es jedoch vorteilhaft, daß die zwei dotierten Bereiche derselben Dotierungsart unterschiedliche Dotierungskonzentrationen aufweisen.

In bestimmten Anwendungsfällen ist es vorteilhaft, daß mindestens einer der zwei dotierten Bereiche aus einem anderen Halbleitermaterial besteht als der Bereich von intrinsischer Leitfähigkeit.

Es gibt auch Anwendungsfälle, in denen es vorteilhaft ist, daß mindestens einer der drei Bereiche aus einem anderen Halbleitermaterial besteht als das Halbleitersubstrat.

Für die Herstellung erfindungsgemäßer Halbleiterdioden ist es vorteilhaft, daß ein semi-isolierendes Halbleitersubstrat aus einem Verbindungshalbleitermaterial mindestens mit zwei getrennten dotierten Bereichen derselben Dotierungsart versehen wird, daß ein Zwischenbereich zwischen den beiden dotierten Bereichen, falls er nicht von intrinsischer Leitfähigkeit ist, als Bereich von intrinsischer Leitfähigkeit ausgebildet wird, daß auf den dotierten Bereichen ohmsche Kontakte abgeschieden werden, daß die Kontakte einlegiert werden, und daß eine ganzflächige Passivierung erfolgt.

Bei gewissen Anwendungsfällen ist es vorteilhaft, daß die dotierten Bereiche mittels Implantation und nachfolgendem Ausheilen eingebracht werden.

In anderen Anwendungsfällen ist es hingegen vorteilhaft, daß die dotierten Bereiche mittels einer ganzflächig epitaktisch aufgebrachten dotierten Halbleiterschicht auf ein Halbleitersubstrat von intrinsischer Leitfähigkeit aufgebracht Halbleiterschicht mittels fotolithographischer Verfahren so strukturiert wird, daß an den Stellen, an denen dotierte Bereiche vorgesehen sind, die dotierte epitaktisch abgeschiedene Halbleiterschicht erhalten bleibt, während an den Stellen an denen Bereiche von intrinsischer Leitfähigkeit vorgesehen sind, die epitaktisch abgeschiedene dotierte Halbleiterschicht bis auf das Substrat von intrinsischer Leitfähigkeit völlig abgetragen wird.

Es ist auch erfinderisch, daß die dotierten Bereiche mittels Epitaxie oder Implantation auf ein Halbleitersubstrat von intrinsischer Leitfähigkeit aufgebracht werden und daß der Bereich von intrinsischer Leitfähigkeit durch eine Isolations-Implantation, z.B. von Sauerstoff- oder Wasserstoff-Ionen, erzeugt wird.

Nachfolgend wird die Erfindung anhand der Zeichnung und an Ausführungsbeispielen näher erläutert. Es zeigen:

Fig. 1 und 2 ein Ausführungsbeispiel der erfindungsgemäßen Halbleiterdiode im Querschnitt und in Draufsicht,

Fig. 3 eine Stromspannungskennlinie einer Halbleiterdiode nach Fig. 1 und 2,

Fig. 4 bis 6 Verfahrensschritte eines erfindungsgemäßen Verfahrens zur Herstellung einer Halbleiterdiode nach Fig. 1 und 2.

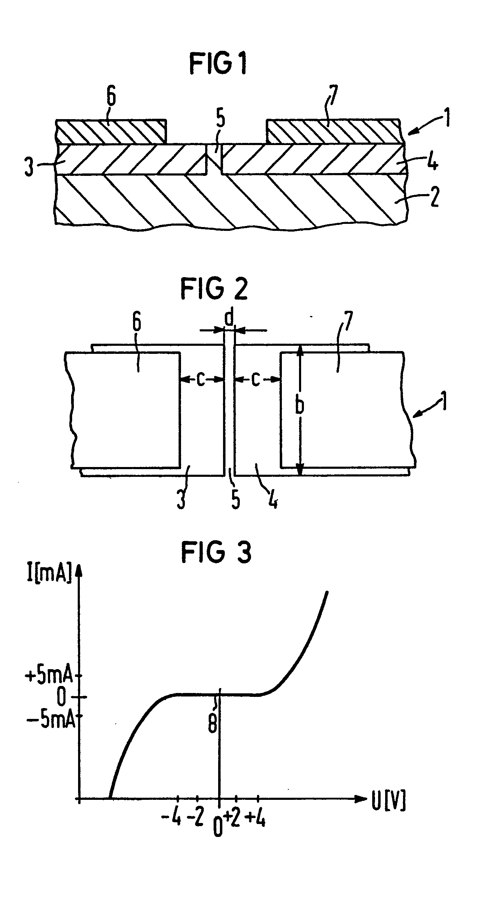

Fig. 1 zeigt ein Ausführungsbeispiel einer erfindungsgemäßen Halbleiterdiode 1. Auf einem Halbleitersubstrat 2, das semi-isolierend ist und aus binären, ternären oder quaternären Verbindungshalbleitern, insbesondere aus Galliumarsenid, Indiumphosphid oder Galliumaluminiumarsenid besteht, befinden sich zwei dotierte Bereiche 3, 4, die die gleiche Dotierungsart, insbesondere eine n-Dotierung, aufweisen. Zwischen den beiden dotierten Bereichen 3 und 4 befindet sich ein Bereich 5 von intrinsischer Leitfähigkeit. Der Bereich 5 von intrinsischer Leitfähigkeit ist entweder als Zwischenbereich zwischen den dotierten Bereichen 3 und 4 von vornherein von intrinsischer Leitfähigkeit, falls das Halbleitersubstrat 2 von intrinsischer Leitfähigkeit ist. Ist das Halbleitersubstrat 2 nicht von intrinsischer Leitfähigkeit, so wird der Bereich 5 als Bereich von intrinsischer Leitfähigkeit ausgebildet. Auf den dotierten Bereichen 3 und 4 sind ohmsche Kontakte 6 und 7 angebracht, insbesondere auf Germanium-Gold-Basis. Zum Beispiel kann auf den dotierten Bereichen 3 und 4 der Reihe nach eine Schichtenfolge von Germanium, Gold, Chrom, Gold oder auch eine Schichtenfolge aus Germanium, Gold, Nickel, Gold angebracht sein.

Fig. 2 zeigt eine Draufsicht auf eine Halbleiterdiode 1 nach Fig. 1. Gleiche Gegenstände sind mit gleichen Bezugzeichen versehen und werden nicht nochmals beschrieben. Außerdem bezeichnet d die Länge der Diode, d.h. die Spaltbreite der Schicht 5 von intrinsischer Leitfähigkeit c den Abstand zwischen Schicht 5 und den auf den dotierten Bereichen 3, 4 angebrachten ohmschen Kontakten 6, 7, b ist die Weite der Diode, d.h. die Erstreckung der dotierten Bereiche 3, 4 parallel zur langen Kante des Bereichs 5 von intrinsischer Leitfähigkeit.

Bei einem speziellen Ausführungsbeispiel mit einem Substrat aus Galliumarsenid (GaAs) und n-dotierten Bereichen 3, 4 von gleicher Dotierungskonzentration, und zwar dotiert mit Silicium, von der Konzentration von ca. $3 \times 10^{17}$ cm$^{-3}$ und mit ohmschen Kontakten der Zusammensetzung Germanium, Gold, Chrom, Gold, (Ge, Au, Cr, Au) wurde b=80 μm, c=1,5 μm und d=1,5 μm gewählt.

Fig. 3 zeigt die Stromspannungskennlinie des in Fig. 2 angegebenen speziellen Ausführungsbeispiels einer Halbleiterdiode 1. Für die speziell gewählten Abmessungen b, c, d und die speziell gewählten Materialien ist, wie aus der Kennlinie 8 ersichtlich der Strom I im Spannungsbereich zwischen ca. −2.5 V bis +2.5 V Null. Bei stärker negativen und auch positiven Spannungen wächst der Strom hingegen rasch an. Durch die spezielle geometrische Gestaltung von erfindungsgemäßen Halbleiterdioden, insbesondere durch die Länge d der Zone 5, mit der der Abstand zwischen den dotierten Bereichen 3 und 4 festgelegt ist, kann die Schwellwertspannung erfindungsgemäßer Halbleiterdioden variiert werden. Eine Bewegung von Ladungsträgern durch den Bereich 5 erfolgt nämlich bei um so geringeren angelegten äußeren Spannungen, je schmaler diese Zone ist.

Erfindungsgemäße Halbleiterdioden sind nicht an die spezielle Formgebung aus Fig. 1 und 2 gebunden; sie können vielmehr in jeder beliebigen geeigneten Geometrie hergestellt werden, z.B. als kreissymmetrisch geformte Dioden.

Erfindungsgemäße Dioden können als Schutzdioden bei z.B. Galliumarsenid-Bauelementen, insbesondere Galliumarsenid-Feldeffekttransistoren angewendet werden. In einem solchen Fall wäre die Halbleiterdiode 1 als Schutzdiode zwischen Gate und Source bzw. Masse zu schalten.

Die erfindungsgemäße Diode eignet sich jedoch auch für alle Anwendungen bei vorgegebenem, insbesondere niederem Schwellwert. Sie eignet sich insbesondere auch als Laufzeitdiode oder als Klammerdiode in Verbindung mit Bipolartransistoren, nämlich zur Erhöhung deren Schaltgeschwindigkeit.

Der Vorteil einer erfindungsgemäßen Halbleiterdiode besteht darin, daß sie als planares Bauelement ausgebildet ist und sich somit zur Integration auch bei Verbindungshalbleitern, z.B. Galliumarsenid-Halbleitern, eignet.

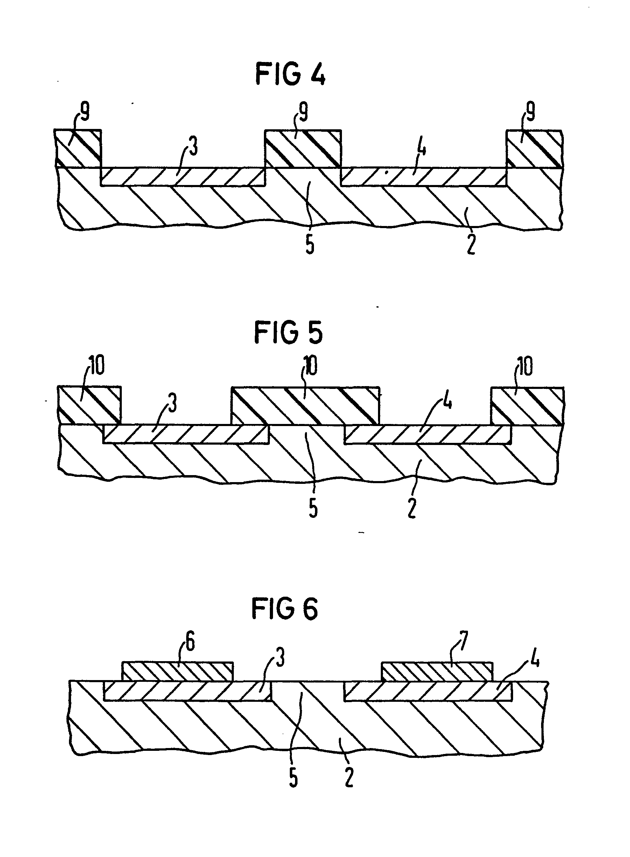

Die Fig. 4 bis 6 verdeutlichen Verfahrensschritte zur Herstellung einer erfindungsgemäßen Halbleiterdiode nach z.B. Fig. 1 und 2.

Fig. 4 zeigt im Querschnitt einen Teil eines Halbleitersubstrats 2 aus einem semi-isolierenden Material, das z.B. aus binären, ternären oder quaternären Verbindungshalbleitern, insbesondere aus Galliumarsenid, Indiumphosphid oder Galliumaluminiumarsenid, besteht. Das Halbleitersubstrat 2 kann von intrinsischer Leitfähigkeit sein. Um die dotierten Bereiche 3, 4 im Substrat anzubringen, wird das Substrat 2 mit einer ersten Fotolackmaske 9 versehen. Die erste Fotolackmaske 9 hat gerade an den Stellen Öffnungen, an denen die dotierten Bereiche 3 und 4 angebracht werden. Mittels Diffusion oder Implantation werden die dotierten Bereiche 3 und 4 in das Substrat 2 an den Stellen der Öffnungen der ersten Fotolackmaske 9 eingebracht. Insbesondere werden n-dotierte Bereiche 3, 4 in das Substrat eingebracht. Sollen die dotierten Bereiche 3, 4 zwar die gleiche Dotierungsart, jedoch unterschiedliche Dotierungskonzentrationen aufweisen, so ist ein zusätzlicher fotolithografischer Prozeß vor dem in Fig. 4 dargestellten Verfahrensschritt anzubringen, der denjenigen dotierten Bereich 3 oder 4 mit der geringeren Dotierungskonzentration zunächst abdeckt und nur denjenigen Bereich zunächst freigibt, der die höhere Dotierungskonzentration aufweisen soll, oder umgekehrt. Erfolgt die Dotierung mittels Implantation, so ist nach den Implantationsschritten ein Ausheilschritt anzubringen, z.B. bei 840°C und z.B. 20 Minuten lang.

Fig. 5 zeigt einen Teil des Halbleiterchips nach Fig. 4, von dem die erste Fotolackmaske 9 entfernt ist und auf den eine zweite Fotolackmaske 10, welche Öffnungen für die anzubringenden ohmschen Kontakte 6 bzw. 7 enthält, aufgebracht ist. In die Öffnung der zweiten Fotolackmaske 10 werden die ohmschen Kontakte 6 und 7 abgeschieden, was z.B. mittels Bedampfung erfolgen kann.

In Fig. 6 ist ein Teil eines Halbleiterchips nach den Fig. 4 und 5 dargestellt, von dem die zweite Fotolackmaske 10 z.B. mittels Abhebetechnik entfernt ist und auf dem ohmsche Kontakte 6 und 7 angebracht sind. Die ohmschen Kontakte 6 und 7 sind insbesondere Kontakte auf Germanium-Gold-Basis und können insbesondere aus einer Schichtenfolge Germanium, Gold Chrom, Gold oder aus einer Schichtenfolge von Germanium, Gold, Nickel, Gold bestehen. Der intrinsische Bereiche 5 befindet sich zwischen den dotierten Bereichen 3 und 4. Der Bereich 5 von intrinsischer Leitfähigkeit ist entweder von vornherein gegeben, wenn das Halbleitersubstrat 2 von intrinsischer Leitfähigkeit ist, oder er wird bei einem Halbleitersubstrat 2 von nicht-intrinsischer Leitfähigkeit durch geeignete Dotierung als Bereich 5 von intrinsischer Leitfähigkeit ausgebildet. Das Halbleitersubstrat besteht aus semi-isolierendem Material und weist in undotiertem Zustand bei Raumtemperatur einen Widerstand $10^4$ Ohm · cm auf.

Anstelle des in den Fig. 4 bis 6 beschriebenen Verfahrens kann auch auf einem Halbleitersubstrat 2 von intrinsischer Leitfähigkeit eine durchgehende, insbesondere n- oder $n^+$-dotierte epitaktisch aufgebrachte Schicht abgeschieden werden. Mit einer Fotolackmaske, die einem Negativ der in Fig. 4 dargestellten Fotolackmaske 9 entspricht, wird mittels Ätzung die n- bzw. $n^+$-dotierte Schicht bis zur Substratoberfläche 2 abgeätzt. Dadurch entsteht wiederum ein Bereich 5 von intrinsischer Leitfähigkeit zwischen den dotierten Bereichen 3 und 4. Zur Anbringung der ohmschen Kontakte 6 und 7 kann das in den Fig. 5 und 6 dargestellte Verfahren verwendet werden.

## Patentansprüche

1. Planarer elektronischer Halbleiter-Bauelement-Körper mit einem semi-isolierenden Substrat (2) aus Verbindungs-Halbleitermaterial, mit einer auf dem Substrat (2) des Halbleiter-Bauelement-Körpers integrierten Halbleiter-Schutzdiode (1) zum Schutz für mindestens ein anderes auf dem Substrat (2) integriertes Halbleiter-Bauelement gegen statische Entladung, wobei die Halbleiter-Schutzdiode (1) aus drei aneinander grenzenden Bereichen (3, 4, 5) besteht, bei denen zwei dotierte Bereiche (3, 5) derselben Dotierungsart durch einen dritten Bereiche (5) getrennt sind und bei denen die zweit dotierten Bereiche (3, 4) derselben Dotierungsart ohmsche Kontakte (6, 7) aufweisen, wobei der dritte Bereich (5) von intrinsischer Leitfähigkeit ist und derartige geometrische Abmessungen aufweist, daß die Halbleiter-Schutzdiode (1) eine vorgegebene Schwellwertspannung aufweist, und wobei die ohmschen Kontakte (6, 7) auf den zwei dotierten Bereichen (3, 4) derselben Dotierungsart einen Abstand (c) zum dritten Bereich (5) hin aufweisen.

2. Planarer elektronischer Halbleiter-Bauelement-Körper nach Anspruch 1, dadurch gekennzeichnet, daß das Halbleitersubstrat (2) aus Galliumarsenid, Indiumphosphid oder Galliumaluminiumarsenid besteht.

3. Planarer elektronischer Halbleiter-Bauelement-Körper nach Anspruch 1 oder 2, dadurch gekennzeichnet, daß die zwei dotierten Bereiche (3, 4) derselben Dotierungsart eine n-Dotierung besitzen.

4. Planarer elektronischer Halbleiter-Bauelement-Körper nach Anspruch 1 oder 2, dadurch gekennzeichnet, daß die zwei dotierten Bereiche (3, 4) derselben Dotierungsart eine p-Dotierung besitzen.

5. Planarer elektronischer Halbleiter-Bauelement-Körper nach einem der Ansprüche 1 bis 4, dadurch gekennzeichnet, daß die zwei dotierten Bereiche (3, 4) derselben Dotierungsart die gleiche Dotierungskonzentration aufweisen.

6. Planarer elektronischer Halbleiter-Bauelement-Körper nach einem der Ansprüche 1 bis 4, dadurch gekennzeichnet, daß die zwei dotierten Bereiche (3, 4) derselben Dotierungsart unterschiedliche Dotierungskonzentrationen aufweisen.

7. Planarer elektronischer Halbleiter-Bauelement-Körper nach einem der Ansprüche 1 bis 6, dadurch gekennzeichnet, daß mindestens einer der drei Bereiche (3, 4, 5) aus einem anderen Halbleitermaterial besteht als das Halbleitersubstrat (2).

8. Verfahren zur Herstellung eines planaren elektronischen Halbleiter-Bauelement-Körpers nach einem der Ansprüche 1 bis 7, dadurch gekennzeichnet, daß ein semi-isolierendes Halbleitersubstrat (2) aus einem Verbindungshalbleitermaterial mindestens mit zwei getrennten dotierten Bereichen (3, 4) derselben Dotierungsart versehen wird, daß ein Zwischenbereich zwischen den beiden dotierten Bereichen (3, 4), falls er nicht von intrinsischer Leitfähigkeit ist, als Bereich (5) von intrinsischer Leitfähigkeit ausgebildet wird, daß auf den dotierten Bereichen (3, 4) ohmsche Kontakte (6, 7) abgeschieden werden daß die ohmschen Kontakte (6, 7) einlegiert werden, und daß eine ganzflächige Passivierung erfolgt.

9. Verfahren nach Anspruch 8, dadurch gekennzeichnet, daß die dotierten Bereiche (3, 4) mittels Implantation und nachfolgendem Ausheilen eingebracht werden.

10. Verfahren nach Anspruch 8, dadurch gekennzeichnet, daß die dotierten Bereiche (3, 4) mittels einer ganzflächig epitaktisch aufgebrachten dotierten Halbleiterschicht auf ein Halbleitersubstrat (2) von intrinsischer Leitfähigkeit aufgebracht werden und daß danach die epitaktisch aufgebrachte Halbleiterschicht mittels fotolithografischer Verfahren so strukturiert wird, daß an denjenigen Stellen, an denen dotierte Bereiche (3, 4) vorgesehen sind, die dotierte, epitaktisch abgeschiedene Halbleiterschicht erhalten bleibt, während an denjenigen Stellen, an denen Bereiche von intrinsischer Leitfähigkeit vorgesehen sind, die epitaktisch abgeschiedene dotierte Halbleiterschicht bis auf das Substrat völlig abgetragen wird.

11. Verfahren nach Anspruch 8, dadurch gekennzeichnet, daß die dotierten Bereiche (3, 4) zunächst mittels ganzflächiger Epitaxie oder Implantation auf ein Halbleitersubstrat (2) von intrinsischer Leitfähigkeit aufgebracht werden, und daß der Bereich (5) von intrinsischer Leitfähigkeit durch eine Isolations-Implantation auf den ganzflächig implantierten oder epitaktisch abgeschiedenen Bereichen erzeugt wird.

12. Verfahren nach Anspruch 11, dadurch gekennzeichnet, daß die Isolations-Implantation durch eine Implantation von Sauerstoff- oder Wasserstoff-Ionen erzeugt wird.

**Revendications**

1. Corps de composant à semiconducteurs électronique planar comportant un substrat semi-isolant (2) formé d'un matériau semiconducteur allié, avec une diode protectrice à semiconducteurs (1) intégrée sur le substrat (2) du corps du composant à semiconducteurs et servant à protéger au moins un autre composant à semiconducteurs intégré sur le substrat (2) vis-à-vis d'une décharge statique, et dans lequel la diode protectrice à semiconducteurs (1) est constituée par trois zones contiguës (3, 4, 5), parmi lesquelles deux zones dopées (3, 4) possédant le même type de dopage sont séparées par une troisième zone (5), et parmi lesquelles les deux zones dopées (3, 4) possédant le même type de dopage possèdent des contacts ohmiques (6, 7), et dans lequel la troisième zone (5) possède une conductivité intrinsèque et a des dimensions géométriques telles que la diode protectrice à semiconducteurs (1) possède une tension de seuil prédéterminée, et dans lequel les contacts ohmiques (6, 7) situés sur les deux zones dopées (3, 4) possédant le même type de dopage sont séparés de la troisième zone (5) par une distance (c).

2. Corps de composant à semiconducteurs électronique planar suivant la revendication 1, caractérisé par le fait que le substrat semiconducteur (2) est constitué par de l'arseniure de gallium, du phosphure d'indium ou de l'arseniure de gallium et d'aluminium.

3. Corps de composant à semiconducteurs électronique planar suivant la revendication 1 ou 2, caractérisé par le fait que les deux zones dopées (3, 4), qui ont le même type de dopage, possèdent un dopage de type n.

4. Corps de composant à semiconducteurs électronique planar suivant la revendication 1 ou 2, caractérisé par le fait que les deux zones dopées (3, 4), qui ont le même type de dopage, possèdent un dopage de type p.

5. Corps de composant à semiconducteurs électronique planar suivant l'une des revendications 1 à 4, caractérisé par le fait que les deux zones dopées (3, 4), qui ont le même type de dopage, possèdent la même concentration de dopage.

6. Corps de composant à semiconducteurs électronique planar suivant l'une des revendications 1 à 4, caractérisé par le fait que les deux zones dopées (3, 4), qui ont le même type de dopage, possèdent des concentrations de dopage différentes.

7. Corps de composant à semiconducteurs électronique planar suivant l'une des revendications 1 à 6, caractérisé par le fait qu'au moins l'une des trois zones (3, 4, 5) est constituée par un matériau semiconducteur différent de celui du substrat semiconducteur (2).

8. Procédé pour fabriquer un corps de composant à semiconducteurs électronique planar suivant l'une des revendications 1 à 7, caractérisé par le fait qu'on ménage dans un substrat semiconducteur semi-isolant (2) réalisé en un matériau semiconducteur allié, au moins deux zones dopées séparées (3, 4) possédant le même type de dopage qu'on réalise une zone intercalaire située entre les deux zones dopées (3, 4) et une zone (5) possédant une conductivité intrinsèque, dans la mesure où cette zone intercalaire n'en possède pas, qu'on dépose des contacts ohmiques (6, 7) sur les zones dopées (3, 4), qu'on fixé par alliage les contacts ohmiques (6, 7) et qu'on réalise une passivation sur l'ensemble de la surface.

9. Procédé suivant la revendication 8, caractérisé par le fait qu'on ménage des zones dopées (3, 4) au moyen d'une implantation et d'un recuit ultérieur.

10. Procédé suivant la revendication 8, caractérisé par le fait qu'on dépose les zones dopées (3, 4) au moyen d'une couche semiconductrice dopée déposée par voie épitaxiale sur toute la surface, sur un substrat semiconducteur (2) possédant une conductivité intrinsèque et qu'ensuite on structure la couche semiconductrice déposée par voie épitaxiale, au moyen de procédés photolithographiques de manière que la couche semiconductrice dopée par voie épitaxiale, subsiste aux emplacements auxquels des zones dopées (3, 4) sont prévues, tandis qu'aux emplacements au niveau desquels des zones possédant une conductivité intrinsèque sont prévues, la couche semiconductrice dopée déposée par voie épitaxiale est complètement éliminée jusqu'au substrat.

11. Procédé suivant la revendication 8, caractérisé par le fait qu'on dépose les zones dopées (3, 4) tout d'abord au moyen d'une épitaxie ou d'une implantation, réalisée sur toute la surface, sur un substrat semiconducteur (2) présentant une conductivité intrinsèque et qu'on forme la zone (5) possédant ls conductivité intrinsèque au moyen d'une implantation d'isolation sur les zones implantées ou déposées par voie épitaxiale sur toute la surface.

12. Procédé suivant la revendication 11, caractérisé par le fait que l'implantation d'isolation est réalisée au moyen d'une implantation d'ions d'oxygène ou d'hydrogène.

**Claims**

1. Planar electronic semiconductor component body having a semi-insulating substrate (2) made of a compound semiconductor material, and having a semiconductor surge protection diode (1), integrated on the substrate (2) of the semiconductor component body, for protecting at least one other semiconductor component integrated on the substrate (2) against static discharge, the semiconductor surge protection diode (1) consisting of three regions (3, 4, 5), which bound one another and in the case of which two doped regions (3, 4) of the same doping type are separated by a third region (5), and in the case of which the two doped regions (3, 4) of the same doping type have ohmic contacts (6, 7), the third region (5) being of intrinsic conductivity and having geometrical dimensions such that the semiconductor surge protection diode (1) has a predetermined threshold voltage, and the ohmic contacts (6, 7) on the two doped regions (3, 4) of the same doping type having a clearance (c) from the third region (5).

2. Planar electronic semiconductor component body according to Claim 1, characterized in that the semiconductor substrate (2) consists of gallium arsenide, indium phosphide or gallium aluminium arsenide.

3. Planar electronic semiconductor component body according to Claim 1 or 2, characterized in that the two doped regions (3, 4) of the same doping type have an n-type doping.

4. Planar electronic semiconductor component body according to Claim 1 or 2, characterized in that the two doped regions (3, 4) of the same doping type have a p-type doping.

5. Planar electronic semiconductor component body according to one of Claims 1 to 4, characterized in that the two doped regions (3, 4) of the same doping type have the same doping concentration.

6. Planar electronic semiconductor component body according to one of Claims 1 to 4, characterized in that the two doped regions (3, 4) of the same doping type have different doping concentrations.

7. Planar electronic semiconductor component body according to one of Claims 1 to 6, characterized in that at least one of the three regions (3, 4, 5) consists of another semiconductor material than the semiconductor substrate (2).

8. Process for producing a planar electronic semiconductor component body according to one of Claims 1 to 7, characterized in that a semi-insulating semiconductor substrate (2) made of a compound semiconductor material is provided at least with two separate doped regions (3, 4) of the same doping type, in that if it is not of intrinsic conductivity an intermediate region between the two doped regions (3, 4) is constructed as a region (5) of intrinsic conductivity, in that ohmic contacts (6, 7) are deposited on the doped regions (3, 4), in that the ohmic contacts (6, 7) are alloyed, and in that passivation is done over the entire surface.

9. Process according to Claim 8, characterized in that the doped regions (3, 4) are introduced by means of implantation and subsequent healing.

10. Process according to Claim 8, characterized in that the doped regions (3, 4) are applied to a semiconductor substrate (2) of intrinsic conductivity by means of a doped semiconductor layer applied epitactically over the entire surface, and in that thereafter the epitactically applied semiconductor layer is structured by means of photolithographic processes in such a way that at those sites at which doped regions (3 4) are provided the doped, epitactically deposited semiconductor layer remains preserved, while at those sites at which regions of intrinsic conductivity are provided the epitactically deposited, doped semiconductor layer is completely eroded as far as the substrate.

11. Process according to Claim 8, characterized in that the doped regions (3, 4) are firstly applied to a semiconductor substrate (2) of intrinsic conductivity by means of epitaxy or implantation over the entire surface, and in that the region (5) of intrinsic conductivity is produced by insulation implantation on the regions implanted over the whole surface or epitactically deposited.

12. Process according to Claim 11, characterized in that the insulation implantation is produced by implantation of oxygen or hydrogen ions.

## FIG 1

## FIG 2

## FIG 3

# FIG 4

# FIG 5

# FIG 6